# EUROPEAN PATENT SPECIFICATION

(11) **EP 0 329 163 B1**
(45) Date of publication and mention of the grant of the patent: **25.05.1994**
(21) Application number: 89102773.2
(22) Date of filing: 17.02.1989
(51) Int. Cl.: C01B 33/02

(54) **Method for forming presized particles from silicon rods**
Verfahren zur Formung von Teilen vorgewählter Grösse aus Siliciumstäben
Compositions compatibles et résistantes au solvant de polyphénylène éthers et de polyesters thermoplastiques

(30) Priority: 18.02.1988 US 156731
(43) Date of publication of application: 23.08.1989
(73) Proprietor: Advanced Silicon Materials, Inc., Moses Lake, Washington 98837 (US)
(72) Inventor: Kun, Leslie Charles, Grand Island (14027) State of New York (US); Van Slooten, Richard Andrew, East Aurora (14052) State of New York (US); Prasad, Ravi, East Amherst (14050) State of New York (US)
(74) Representative: Brandes, Jürgen, Dr.

(56) References cited:
- DE-A- 3 428 255
- GB-A- 1 066 848
- CHEMICAL ABSTRACTS vol. 111, no. 8, 21 August 1989, page 153, abstract no. 60438u, Columbus, Ohio, US; & JP - A - 0114110 (MITSUI TOATSU CHEMICALS, INC.) 18.01.1989

## Description

### BACKGROUND OF INVENTION

This invention relates to a method for fracturing polycrystalline silicon rods into particles within a predetermined size range and in a predetermined size distribution. The method of fracture also forms particles with blunt edges.

Polycrystalline silicon rods are used in the manufacture of single crystal silicon rods for use in the semiconductor industry. The single crystal rods are processed into silicon wafers from which semiconductor silicon chips are made.

Polycrystalline silicon rods are made by the pyrolytic decomposition of a gaseous silicon compound, such as silane, upon a heated, rod shaped, filament of silicon or of another high melting point metal filament having sufficient electrical conductivity, such as tungsten or tantalum. The principles upon which present state of the art reactors are designed for the pyrolysis of silane are set forth in, for example, U.S. -A-3,147,141, 4,147,814 and 4,150,168.

The pyrolysis of silane to form silicon and hydrogen occurs in a reactor containing a plurality of silicon filament rods. The rod is grown to a diameter of generally between 7-12 cm. Thereafter, the rods are harvested from the reactor and broken up into small pieces. The pieces are sorted by size to satisfy certain size distribution requirements for processing into a single crystal in accordance with the known Czochralski crystal pulling process. The size distribution for the polycrystalline particles is determined from the melting crucible specification to maximize packing density of the particles

The polysilicon rods must be fractured so as to avoid contamination. Each handling operation increases the potential for contamination. Presently each rod is carefully placed upon a metal trough and struck with a hammer by a skilled human operator. The operator is trained to apply sufficient force at selected locations along the length of the rod to cause the rod to fracture into relatively large size pieces within a predetermined size range. Particles which fall outside the predetermined size range have to be marketed at substantially reduced prices. Experience shows that even the most skilled operators find it difficult to control the fracture of the silicon rods into particles within a desired size range.

The present method has many undesirable characteristics. It is intrinsically a slow process and requires skilled personnel. The amount of force needed to fracture the rod results in excessive operator fatigue and may cause health related problems over time. A substantial number of handling steps are presently required.

The degree of physical force presently required to fracture the rod also tends to generate minute wear fragments from the hammer and table. These minute wear particles transfer to the polycrystalline rod surface upon impact thereby further contributing to contamination.

The present method of fracture also results in particles with exceedingly sharp edges. This is unacceptable for many reasons. The sharp edges make the particles very difficult to handle and increase the handling time necessary to avoid personal injury. Even minor skin puncture can contaminate the silicon material. To minimize this problem the fragmented particles are presently fed into a rotating drum tumbler where the edges are blunted. The particles are then sorted using metal sieves to separate the fines. The larger particles are then segregated into three separate ranges in a desired size distribution.

Finally, fracturing the polysilicon rods with a hammer forms a fine silicon powder in addition to the fractured particles. The fine powder has a tendency to stick to the surface of the fractured particles. During crucible melting the fines float on the surface of the melt and can interfere with the Czochralksi process. To remove the powder from the product, the additional step of washing the particles in deionized water is required.

In accordance with the method of the present invention, polycrystalline silicon rods are fractured into particles of predetermined sizes and in a predetermined size distribution relative to one another. The fractured particles produced by the subject invention do not have sharp edges and there is essentially no powder formed.

The method of the present invention broadly comprises pretreating the polysilicon rod by inducing micro and macro stress cracks inside the rod. The pretreated rod is then readily fractured into pieces by striking the rod with minimal force. The level of mechanical work needed to break the precracked rod into small pieces is only a fraction of the work required to fracture an untreated rod. A preferred embodiment for inducing micro and macro cracking in the rod is to heat the rod to within a predetermined temperature of between 205 to 315°C followed by relatively rapid cooling. An alternative embodiment for inducing micro and macro cracks in the rod is to introduce a high velocity compression wave at one end of the rod of between 3 - 4.6 m/s (10-15 ft/sec.) with a preferred mass ratio between the impinging body to the polysilicon rod of between 0.05 to 1.

### OBJECTS AND BRIEF DESCRIPTION OF DRAWINGS

The present invention refers to a method of forming silicon particles comprising the steps of appended claim 1.

It is the principle object of the present invention to provide a method for fracturing high purity polycrystalline silicon rods into particles having predetermined sizes in a predetermined size distribution. It is a further object of the present invention to provide a method for fracturing high purity polycrystalline silicon rods into particles which do not exhibit any sharp edges.

These and other objects and advantages of the present invention will become apparent from the following detailed description of the invention when read in conjunction with the accompanying drawings of which:
Figure 1 is a graphical illustration of the optimum particle size distribution of fractured particles of polycrystalline silicon rod for forming single crystal silicon rods and a superimposed typical distribution of polysilicon particles using the prior art fracturing method;
Figure 2 is a graphical illustration of the particle size distribution of fractured polycrystalline rod using the method of the present invention superimposed on the optimum particle size distribution of fractured particles for forming single crystal silicon rods;
Figure 3 is a graph showing the relationship between the applied temperature for heat pretreatment and the percentage of waste particles which are generated by fracturing the rod at corresponding pretreated temperatures;
Figure 4A is a photomicrograph of a fractured prior art polycrystalline silicon particle;
Figure 4B is a photomicrograph of a fractured polycrystalline silicon particle produced in accordance with the method of the present invention; and
Figure 5 is a graphical illustration of the edge characteristics for fractured particles comparing sharpness to dullness based on the relationship between the edge radius to the edge angle.

Single crystal silicon metal is formed from high purity polycrystalline silicon. High purity silicon rods are first formed by the pyrolysis of silane gas in a pyrolytic reactor. Once the rods are grown to desired diameter of e.g. 7-12 cm. they are harvested, broken and sorted into presized particles. Particles between two to four inches in size are preferred for melting in a crucible to form a single crystal silicon metal using the conventional Czochralski crystal pulling process.

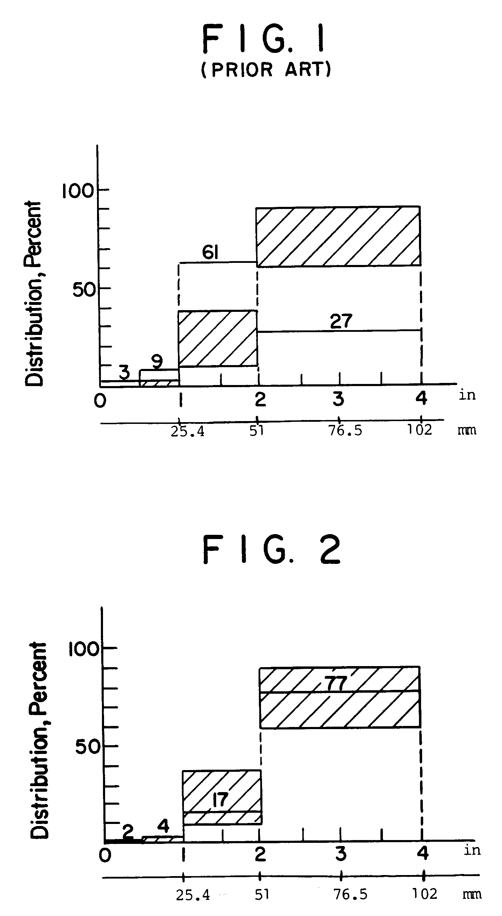

The distribution of fractured particles from a polycrystalline silicon rod using the prior art method is shown in Figure 1 superimposed upon the optimum particle size distribution for forming a single crystal silicon rod using the above indicated Czochralski crystal pulling process. The optimum size distribution among particles of from 0-102 mm (0 to 4 inches) in size is shown using shaded boxes. Accordingly, the optimum size range for particles of between 51-102 mm (2 to 4 inches) in size should be between 60 to 90 percent of the total of fragmented particles and for particles of between one to two inches the optimum size range should be between 10 to 38 percent of the total. Particles below 12.7 mm (0.5 inch) in size are undesirable and particles in the size range of between 12.7 -25.4 mm (0.5 to 1 inch) should be less than 3 percent of the total. The distribution between particles generated using the prior art method typically results in a maximum of about 27 percent in the 51-102 mm (2 to 4 inch) size range and 61 percent in the 25.4 -51 mm (1 to 2 inch) size range. In the 12.7-25.4 mm (0.5 to 1 inch) range, the particles generated by the prior art method typically represent 9 percent of the total and upwards of 3 percent of the total particle distribution falls under 12.7 mm (0.5 inch) in size. In comparison, as shown in Figure 2, the method of the present invention results in a particle size distribution which falls directly within the optimum size range. Typically up to 77 percent of the particles fall into the preferred 51-102 mm (2 to 4 inches) size range and 17 percent between 25.4-51 mm (1 to 2 inches) in size. Four percent of the particles are between 12.7 -25.4 mm (0.5 to 1 inch) in size and less than 2 percent falls under 12.7 mm (0.5 inch) in size.

The method of the present invention consists of forming polycrystalline silicon rods by the pyrolysis of silane gas within a reactor vessel containing silicon starter rods, pretreating the rods formed in the reactor vessel to introduce substantial micro and macro stress cracks and breaking the stressed rods into a substantial number of pieces. The pretreatment of the rods are carried out by controlled heating and cooling of the polycrystalline rods or by precracking the rods by means of impact loading.

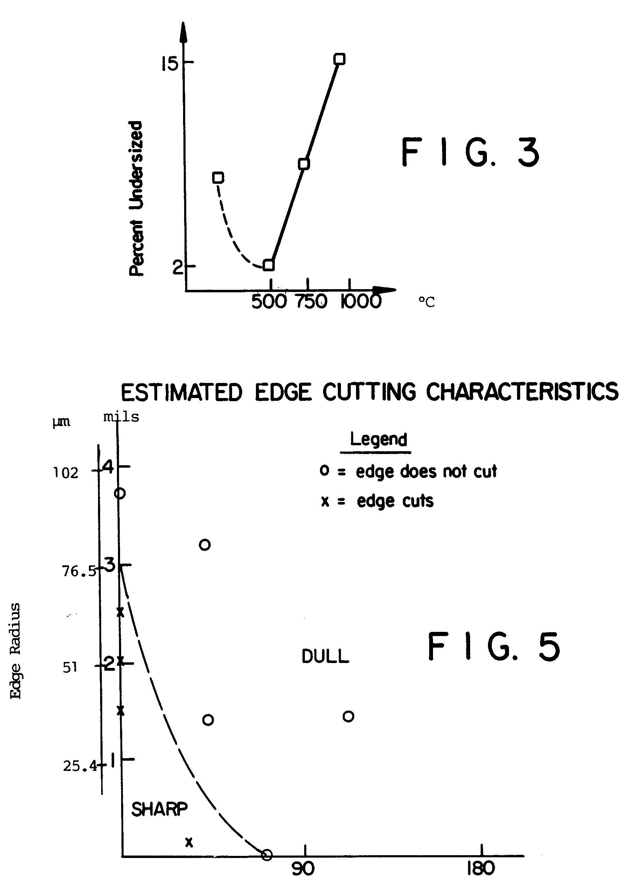

Heat treatment is preferably accomplished by placing the rods in a furnace and raising the temperature in the furnace to a level high enough to introduce substantial thermal stress resulting in micro and macro cracks during the subsequent quenching. It has been discovered that a relationship exists between the applied heat treating temperature and the resulting particle size distribution after the rods are cooled and broken. Particle size below 12.7 mm (0.5 inch) in size, and in particular particle fines, are classified as waste. Figure 3 shows a plot of undersized particles which will be generated in percent upon breaking the rod following heat treatment at the corresponding heat treating temperature. The percentage of undersized particles drops substantially in the heat treating temperature range of between 121°C (250°F) and 400°C (750°F) with the optimum heat treating temperature range lying between 250°C (400°F) and 330°C (625°F). The rods may be heated in a furnace of the still, forced convection or radiative type. The furnace may employ an inert gas or other gas blanketing technique to prevent contamination of the product. Other types of heating include induction, microwave and Joule heating (electrical).

After the rods have been heated, they are removed from the furnace and cooled. Any conventional cooling method may be used. The preferred method of cooling is to quench the rods in water. Deionized water can be used for quenching the rods or alternatively the rods may be cooled in air or other gaseous coolant using forced convection. When the rods are cooled in water, crackling sounds are invariably omitted and macrocracks may be observable on the surface.

As an alternative to heat treatment, the rods may be precracked by application of a suddenly applied load at one end of the rod preferably with the rod suspended. The preferred mass ratio between the impacting body and the polysilicon body should be between 0.05 to 1 and the impacting velocity for the impact load should have a value of between 3 and 45.7 m/s (10 ft/sec. and 150 ft/sec). The impacting body will form a compression wave in the polycrystalline silicon body at the end upon which it is hit which will travel through the polycrystalline silicon body to the opposite end. A reflected tension wave will travel back from the end opposite the original end of impact. It is important to note that the velocity of the compression wave is quite high, in the order of approximately 5486.4 m/s (18,000 ft./sec.) and that the stress levels generated by this wave can also be very high.

Stress values between 6900 and 20700 N/cm² (10,000-30,000 lb./in.²) or even higher can be attained with practical weight and velocity combinations which can be easily determined by those skilled in the art of engineering mechanics. As the stress wave travels in the rod, it will combine with internally locked in stresses and based upon the magnitude and orientation of the stresses the tension wave will produce cracks in the rod. Since the crack propagation velocity is approximately one-third that of the stress wave velocity, the travelling stress wave will leave a trail of fractured zone behind. The stresses sometimes are even high enough to break the rod completely, usually near the end opposite the end of impact. If such a prefractured rod is suspended and hit, it will emit a muffled sound without ringing indicating high internal damping due to the microcracks present.

Such a prefractured rod can now easily be broken by a hand held hammer or by a pneumatic hammer. Although suspending the rod is preferred when applying a compression wave it is not essential. The rod may also be supported along its length in a "V", "U" or other appropriately shaped open brace while impacting a free end. A pneumatic or magnetically driven hammer or any like mechanism, or simply a pendulum may be used to cause the compression wave.

Pretreatment of the polysilicon rod in accordance with the present invention also alters the character and nature of the fracture. The geometry of the fracture becomes more conchoidal with the cleavage planes forming blunt angles. The conchoidal fracture also promotes the generation of the larger particle sizes.

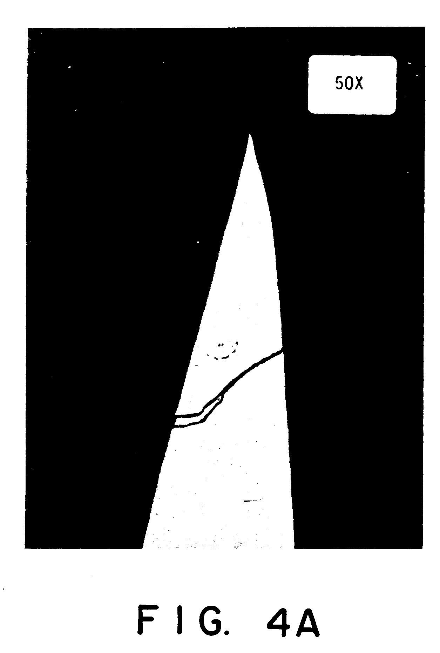

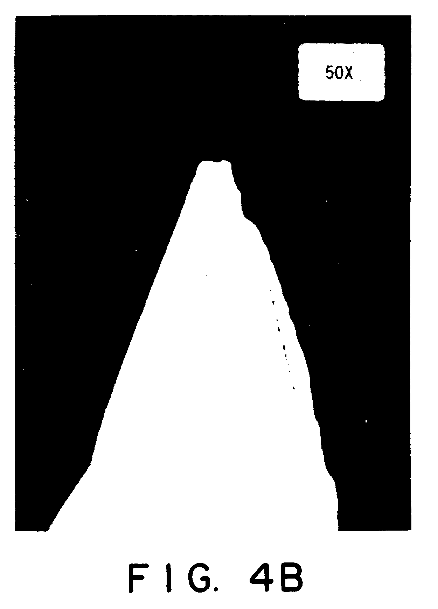

A significant advantage of the use of heat treatment for forming internal stress within the polysilicon rod is the elimination of sharp edges. Figure 4A shows a micrograph of a cross section of a fractured edge of a polysilicon particle formed by the prior art method whereas Figure 4B shows a similar micrograph of a similar particle formed following heat treatment in accordance with the present invention.

Figure 5 is a graphical illustration of the edge characteristics for any fragmented particle. The cutting characteristic of an edge is a function of both the edge angle and radius. Obviously a flat surface will not cut. On the other extreme, paper will cut only if it is thin enough so that the edge radius is small. These boundary conditions are shown on the graph of Figure 5 with the estimated curve for intermediate conditions. Thus, it is estimated that with an edge angle of 30°, edge radii greater than 25 µm (1.0 mils) will result in a dull edge that will not cut. It should be noted that for purposes of this explanation, cutting is being used in the context for hand handling of the silicon particles. Such handling is used for manual loading of the silicon into the Czochralski melting crucibles. The individual points indicated in the graph are based on measurements taken from actual silicon material obtained from the breakage of silicon rods with and without the described invention and from paper in the case of zero edge angle. Only usable size material was considered, that is, powder and granular fines were not included. It is clear that the thermally precracked material can be readily handled without cutting, whereas otherwise skin cutting will occur due to the sharp cutting edges of the fragmented pieces.

## Claims

1. A method of forming silicon particles comprising the steps of:
growing a solid polycrystalline silicon rod by the pyrolytic decomposition of a gaseous silicon compound upon a heated, rod shaped filament;
pretreating the solid polycrystalline rod by
(a) heat treating the rod at a temperature of 205 to 315°C and quenching the heat treated rod in water to introduce stress cracks into the rod, or
(b) suspending or supporting the rod and impacting the suspended or supported rod at one end thereof with a load at an impact velocity of between 3 and 45.7 m/s, the mass ratio between the load and the rod being from 0.05:1 to 1:1, the impact being of sufficient magnitude to impart a compression wave which travels from the one end to the opposite end of the rod and introduces stress cracks into the rod; and
after the stress cracks have been introduced, breaking the pretreated rod into pieces no more than 102 mm in size by impacting the pretreated rod.

2. The method as defined in claim 1 wherein the polycrystalline silicon rod used was prepared by pyrolysis of silane gas within a reactor vessel.

## Patentansprüche

1. Verfahren zum Formen von Siliciumteilen, mit den Arbeitsschritten:
- Züchtung eines massiven Stabes aus polykristallinem Silicium durch pyrolitisches Zersetzen einer gasförmigen Siliciumverbindung auf einem erwärmten, stabförmigen Filament,
- Vorbehandlung des massiven polykristallinen Stabes durch
a) Wärmebehandlung des Stabes bei einer Temperatur von 205 bis 315 °C und Abschreckung des wärmebehandelten Stabes in Wasser, derart, daß im Stab Spannungsrisse entstehen, oder
b) Aufhängung oder Abstützung des Stabes und Aufbringung einer Last auf ein Ende des aufgehängten oder abgestützten Stabes mit einer Auftreffgeschwindigkeit von zwischen 3 und 45,7 m/s, wobei das Massenverhältnis zwischen Last und Stab zwischen 0,05:1 bis 1:1 beträgt, der Stoß von ausreichender Stärke ist, um eine Druckwelle aufzudrücken, die von dem einen Ende zum entgegengesetzten Ende des Stabes wandert und im Stab Spannungsrisse entstehen läßt, und
- nach Entstehenlassen der Spannungsrisse Brechen des vorbehandelten Stabes in Stücke nicht größer als 102 mm durch Schlagen des vorbehandelten Stabes.

2. Verfahren nach Anspruch 1, bei dem der verwendete Stab aus polykristallinem Silicium durch Pyrolyse von Silangas in einem Reaktorgefäß hergestellt wurde.

## Revendications

1. Procédé de formation de particules de silicium, procédé comprenant les étapes suivantes:
- croissance d'une barre massive en silicium polycristallin par la décomposition pyrolitique d'un composé gazeux de silicium sur un filament chauffé sous la forme d'une barre,
- traitement préalable de la barre polycristalline massive par
a) un traitement thermique de la barre à une température comprise entre 205 et 315 °C, et trempe à l'eau de la barre après traitement thermique, de manière à provoquer la formation de criques de tension dans la barre, ou
b) l'accrochage ou la suspension de la barre et l'application de chocs à la barre accrochée ou suspendue, à l'une de ses extrémités, au moyen d'une charge avec une vitesse au choc comprise entre 3 et 45,7 m/sec, le rapport de masses entre la charge et la barre allant de 0,05:1 à 1:1, le choc étant d'une grandeur suffisante pour infliger une onde de choc de compression qui se propage de l'une extrémité vers l'extrémité opposée de la barre et provoque la formation de criques de tension dans la barre, et
- après la formation des criques de tension, cassure de la barre préalablement traitée en des pièces d'une taille ne dépassant pas 102 mm, en appliquant des chocs à la barre préalablement traitée.

2. Procédé selon la revendication 1, dans lequel la barre utilisée en silicium polycristallin avait été préparée par la pyrolyse du gaz de silane dans une cuve de réacteur.
